# FASCICULE DE BREVET EUROPEEN

(11) **EP 2 146 433 B1**
(45) Date de publication et mention de la délivrance du brevet: **30.11.2011**
(21) Numéro de dépôt: 09164952.5
(22) Date de dépôt: 08.07.2009
(51) Int. Cl.: H03K 19/0175, H03K 19/0185, G06F 1/32

(54) **Dispositif de sauvegarde de la configuration de terminaux d'un circuit intègre, et procédé de mise en action du dispositif**
Vorrichtung zum Sichern der Konfiguration von Endgeräten eines integrierten Schaltkreises und Verfahren zur Aktivierung dieser Vorrichtung
Device for backing up the configuration of terminals of an integrated circuit, and method of implementing the device

(30) Priorité: 17.07.2008 EP 08160648
(43) Date de publication de la demande: 20.01.2010
(73) Titulaire: EM Microelectronic-Marin SA, 2074 Marin (CH)
(72) Inventeur: Théoduloz, Yves, 1400 Yverdon (CH); Jaeggi, Hugo, 2046 Fontaines (CH); Plavec, Lubomir, 262 13 Necin (CZ)
(74) Mandataire: Ravenel, Thierry Gérard Louis

(56) Documents cités:
- JP-A- 2003 295 988
- US-A- 6 107 832
- US-A1- 2007 008 787
- US-B1- 6 323 687
- US-B1- 6 980 035
- US-B2- 6 882 200

## Description

L'invention concerne un dispositif de sauvegarde de la configuration de terminaux d'un circuit intégré à basse consommation. Le dispositif de sauvegarde comprend au moins une unité à décalage de niveau de tension, qui comprend un circuit à décalage de niveau de tension et une cellule mémoire. Le circuit à décalage de niveau de tension comprend un étage d'entrée alimenté sous une tension régulée interne et une partie de transfert d'un état d'une fonction en sortie, qui est alimentée sous une tension d'alimentation du circuit intégré. Le dispositif de sauvegarde comprend également un étage de sortie alimenté sous la tension d'alimentation du circuit intégré, qui est relié à la sortie de l'unité à décalage de niveau de tension et connecté à au moins une plage de contact externe du circuit intégré.

L'invention concerne également un procédé de mise en action du dispositif de sauvegarde de la configuration de terminaux d'un circuit intégré à basse consommation.

On entend par terminal toute borne de sortie d'unités électroniques d'un circuit intégré, ainsi qu'une liaison à une plage de contact externe dudit circuit intégré.

Habituellement pour pouvoir diminuer la consommation électrique d'un circuit intégré par exemple dans un mode de repos, il existe différents moyens électroniques connus. Il peut être envisagé par exemple de couper la tension d'alimentation du circuit intégré. Dans ce mode de coupure de l'alimentation (power down en terminologie anglaise), l'état des fonctions intégrées dans ledit circuit intégré n'est plus garanti, ce qui fait que les terminaux de sortie perdent leur configuration. Il doit donc être pris certaines précautions spécifiques depuis l'extérieur du circuit intégré pour s'assurer des problèmes d'incompatibilité entre les terminaux. Cela peut nécessiter l'ajout d'un élément de tirage vers le haut ou d'un élément de tirage vers le bas.

Le document de brevet JP 2003-295988 décrit un circuit intégré muni de moyens pour réduire la consommation électrique dudit circuit intégré dans un mode de repos. Pour ce faire, il comprend au moins une unité à décalage de niveau de tension, qui est alimentée d'une part par une tension régulée interne, et d'autre part par une tension haute d'alimentation du circuit intégré. Le circuit intégré comprend également entre l'unité à décalage de niveau de tension et une plage de contact externe, une cellule mémoire. De cette manière, la configuration d'un terminal de sortie est maintenue dans un mode basse consommation par ladite cellule mémoire.

Pour mémoriser l'état d'un terminal de sortie du circuit intégré de ce document de brevet JP 2003-295988, le logiciel du circuit intégré opère en deux étapes. Une première étape est de tout d'abord mémoriser dans la cellule mémoire l'état du terminal de sortie, et une seconde étape est de passer en mode basse consommation en laissant dans un état flottant les parties alimentées par la tension régulée interne, qui est déconnectée. Cependant le circuit intégré proposé ne peut s'appliquer qu'à la mémorisation de l'état d'un seul terminal de sortie. Dans le cas de la sauvegarde en sortie de la configuration de plusieurs terminaux relatifs à plusieurs fonctions spécifiques, ce circuit intégré devrait comprendre plusieurs blocs fonctionnels en plus. L'ajout de ces blocs fonctionnels complique la conception du circuit intégré, car il doit être garanti également dans le circuit intégré de bons niveaux logiques lors du passage du mode de repos au mode de fonctionnement normal.

Dans le document de brevet US 6,882,200, il est décrit un circuit intégré, qui comprend des moyens pour sauvegarder l'état de terminaux en sortie du circuit intégré dans un mode de repos. Pour ce faire, il comprend un circuit logique pour fournir des signaux de contrôle, qui est alimenté sous une tension régulée, un décaleur de niveau de tension alimenté à une tension d'alimentation du circuit intégré, qui est relié au circuit logique pour décaler en tension l'état des signaux de contrôle. Le décaleur de niveau de tension est relié en sortie à deux cellules mémoires pour mémoriser l'état de deux sorties du décaleur de niveau de tension dans un mode de repos où la tension régulée est coupée. Ces cellules mémoires sont reliées à un étage de sortie connecté à une plage de connexion externe du circuit intégré. Cependant, ce document ne décrit pas la possibilité de sauvegarder l'état en sortie de fonctions spécifiques de plusieurs décaleurs de niveau de tension.

L'invention a donc pour but de fournir un dispositif de sauvegarde de la configuration de terminaux d'un circuit intégré dans un mode basse consommation ou de repos tout en évitant une surconsommation dans ce mode de repos et en palliant les inconvénients de l'état de la technique cité.

A cet effet, l'invention concerne un dispositif de sauvegarde de la configuration de terminaux d'un circuit intégré à basse consommation cité ci-devant, qui se caractérise en ce que le dispositif de sauvegarde comprend plusieurs unités à décalage de niveau de tension reliées en sortie à l'étage de sortie, les unités à décalage de niveau de tension comprenant chacune une cellule mémoire alimentée par la tension d'alimentation et commandée par un même signal de mémorisation, pour mémoriser l'état de sortie en tension d'une fonction spécifique de l'unité à décalage de niveau respective dans un mode de repos du circuit intégré, où la tension régulée est coupée.

Des formes d'exécution particulières du dispositif de sauvegarde sont définies dans les revendications dépendantes 2 à 9.

Un avantage du dispositif de sauvegarde réside dans le fait que dans le mode basse consommation ou de repos, chaque cellule mémoire des unités à décalage de niveau de tension mémorise l'état du terminal de sortie correspondant. Pour ce faire, un signal de mémorisation est appliqué à chaque cellule mémoire en même temps pour commander la mémorisation de l'état de chaque terminal de sortie des unités à décalage du niveau. Ce signal de mémorisation doit intervenir avant le passage du mode de fonctionnement normal au mode de repos.

Un avantage supplémentaire du dispositif de sauvegarde réside dans le fait que dans le mode basse consommation ou de repos, des moyens de blocage sont prévus dans la partie de transfert d'un état en sortie dans chaque unité à décalage de niveau de tension. Ces moyens de blocage permettent de couper tous les courants transversaux de la partie de transfert et peuvent fixer un état défini en sortie de chaque unité. Ces courants transversaux apparaissent du fait que la tension régulée interne est placée dans un état flottant sans garantir un blocage de tous les transistors de chaque unité. Ainsi, ils subsistent des noeuds flottants de transistors dans cette partie de transfert, ce qui peut induire les courants transversaux. Grâce à ces moyens de blocage, cela permet de n'avoir que des courants de fuites des éléments alimentés par la tension d'alimentation du circuit intégré dans ce mode de repos.

L'invention concerne encore un procédé de mise en action du dispositif de sauvegarde de la configuration de terminaux d'un circuit intégré à basse consommation cité ci-devant, le procédé comprenant pour le passage d'un mode de fonctionnement normal à un mode de repos et inversement, les étapes consistant à :
- commander au moyen d'un même signal de mémorisation, les cellules mémoires de toutes les unités à décalage de niveau de tension pour la mémorisation par chaque cellule mémoire du dernier état de sortie des terminaux de sortie des unités à décalage du niveau de tension,
- commander le passage du mode de fonctionnement normal au mode basse consommation ou de repos, dans lequel la tension régulée interne est coupée ou devient flottante, le dernier état de sortie des terminaux étant maintenu par les cellules mémoires activées par le signal de mémorisation,
- réveiller après un laps de temps déterminé ou suite à une commande externe, le dispositif de sauvegarde pour le passage du mode de repos au mode de fonctionnement normal avec la tension régulée en fonction, le dernier état de sortie des terminaux de sortie étant maintenu par les cellules mémoires activée par le signal de mémorisation, et
- désactiver le signal de mémorisation pour changer selon les signaux de données ou de contrôle la configuration des terminaux de sortie de chaque unité à décalage du niveau de tension.

Des étapes particulières du procédé de mise en action du dispositif de lecture sont définies dans les revendications dépendantes 11 et 12.

Un avantage du procédé de mise en action du dispositif de sauvegarde réside dans le fait qu'une fois que la configuration des terminaux de sortie des unités à décalage de niveau de tension est mémorisée, il est possible de passer dans un mode basse consommation. Chaque cellule mémoire desdites unités à décalage de niveau de tension, maintient l'état de sortie jusqu'à ce que le dispositif de sauvegarde passe du mode de repos au mode de fonctionnement normal. Dans le mode basse consommation, tous les courants transversaux sont supprimés dans les unités à décalage de niveau de tension par des moyens de blocage, ce qui garantit une faible consommation du circuit intégré.

Les buts, avantages et caractéristiques du dispositif de sauvegarde de la configuration de terminaux d'un circuit intégré à basse consommation, et de son procédé de mise en action apparaîtront mieux dans la description suivante de manière non limitative d'au moins une forme d'exécution illustrée par les dessins sur lesquels :
la figure 1 représente de manière simplifiée les éléments du dispositif de sauvegarde de la configuration des terminaux du circuit intégré selon l'invention,
la figure 2 représente de manière simplifiée une unité à décalage de niveau de tension qui comprend une cellule mémoire du dispositif de sauvegarde selon l'invention, et
la figure 3 représente une forme d'exécution détaillée d'une unité à décalage de niveau de tension ayant une cellule mémoire du dispositif de sauvegarde selon l'invention.

Dans la description suivante, toutes les parties du dispositif de sauvegarde de la configuration de terminaux d'un circuit intégré à basse consommation, qui sont bien connues d'un homme du métier dans ce domaine technique, ne sont relatées que de manière simplifiée.

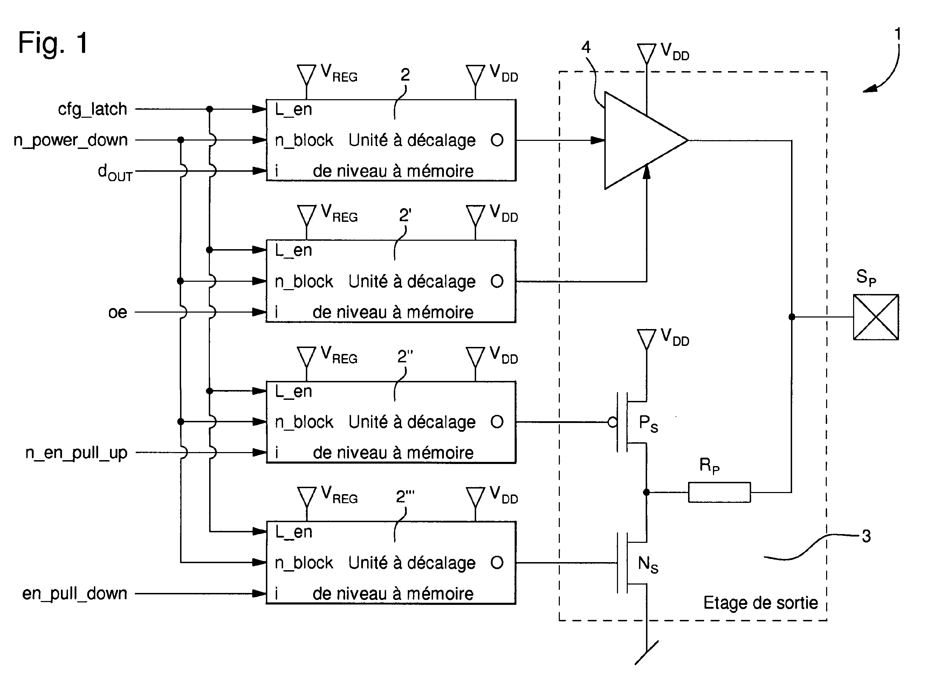

La figure 1 représente un dispositif de sauvegarde 1 de la configuration de terminaux de sortie d'un circuit intégré. Ce dispositif de sauvegarde comprend un ensemble d'unités à décalage de niveau de tension 2, 2', 2" et 2"' et un étage de sortie 3 disposé entre chaque sortie O de chaque unité et au moins une plage de contact externe S_{P} du circuit intégré. Chaque unité à décalage du niveau de tension comprend un étage d'entrée et une partie de transfert d'un état d'une fonction en sortie non représentés. L'étage d'entrée de chaque unité est alimenté par une tension régulée interne V_{REG}, alors que la partie de transfert d'un état d'une fonction est toujours alimentée à une tension d'alimentationV_{DD} du circuit intégré, qui peut être de niveau supérieur ou inférieur à la tension régulée. La tension régulée interne peut être générée par un régulateur de tension à l'intérieur du circuit intégré.

L'étage d'entrée est prévu pour recevoir à une entrée i des signaux de données ou de contrôle d_{OUT}, oe, n_en_pull_up et en_pull_down relatifs à la fonction de chaque unité en liaison par l'étage de sortie à la plage de contact externe S_{P}. Ces signaux de données ou de contrôle proviennent d'une partie logique non représentée du circuit intégré du domaine de la tension régulée interne V_{REG}. Les signaux peuvent être par exemple à un état "1" proche de la tension régulée interne ou à un état "0" proche de la masse. La partie de transfert d'un état d'une fonction, qui est dépendante d'un signal de données i ou de contrôle en entrée, permet le décalage en tension à la sortie O de l'état du signal de données ou de contrôle.

Dans la configuration représentée à la figure 1, le dispositif de sauvegarde est capable de mettre en fonction la fourniture de données D_{OUT} en sortie (Output Enable en terminologie anglaise) par l'intermédiaire d'une première unité à décalage de niveau 2. La sortie O de cette première unité à décalage de niveau, qui est dans le domaine de la tension d'alimentation V_{DD} du circuit intégré, est fournie à une porte de transfert à trois états 4 (buffer tristate en terminologie anglaise) de l'étage de sortie 3, afin de transmettre ces données par la plage de contact externe S_{P}. La porte de transfert, qui est alimentée à la tension d'alimentation du circuit intégré, est mise en fonction par un signal de contrôle oe fourni en entrée d'une seconde unité à décalage de niveau 2' et décalé en tension en sortie O de la seconde unité.

Une troisième unité à décalage de niveau de tension 2" est prévue pour la fonction de tirage vers le haut de la plage de contact externe, alors qu'une quatrième unité à décalage de niveau de tension 2"' est prévue pour la fonction de tirage vers le bas de la plage de contact externe S_{P}. Pour ce faire, la sortie O de la troisième unité à décalage de niveau 2" est reliée à une grille d'un transistor PMOS P_{S} de l'étage de sortie 3, alors que la sortie O de la quatrième unité à décalage de niveau 2"' est reliée à la grille d'un transistor NMOS N_{S} de l'étage de sortie 3. Ces deux transistors sont reliés en série entre la borne de la tension d'alimentation V_{DD} et la borne de masse. Le noeud de connexion des drains des deux transistors P_{S} et N_{S} est relié via une résistance de charge R_{P} à la plage de contact externe S_{P}.

Cependant les troisième et quatrième unités à décalage de niveau de tension ne doivent pas commander le tirage vers le haut ou le tirage vers le bas, lors d'un transfert de données par la première unité à décalage de niveau de tension 2, quand le signal de contrôle oe est à l'état "1", par exemple proche de V_{REG}. De plus quand un tirage vers le haut est commandé avec un signal de contrôle n_en_pull_up à l'état "0" par la troisième unité à décalage 2", le transistor P_{S} devient conducteur, alors que le transistor N_{S} doit rester non conducteur avec le signal de contrôle en_pull_down à l'état "0". Quand un tirage vers le bas est commandé avec le signal de contrôle en_pull_down à l'état "1" par la quatrième unité à décalage 2"', le transistor N_{S} devient conducteur, alors que le transistor P_{S} doit rester non conducteur avec le signal de contrôle n_en_pull_up à l'état "1", par exemple proche de V_{REG}.

Il doit être pris garde lors du passage d'une fonction de tirage vers le haut à une fonction de tirage vers le bas ou inversement, pour ne pas avoir les deux transistors conducteurs. Un temps de pause doit généralement être observé dans lequel les deux transistors P_{S} et N_{S} sont non conducteurs avant d'opérer le changement de fonction souhaité.

Chaque unité à décalage du niveau de tension destinée à remplir une fonction spécifique comprend en plus d'un circuit traditionnel à décalage du niveau de tension, une cellule mémoire non représentée à la figure 1. Cette cellule mémoire est commandée par le signal de mémorisation cfg_latch fourni à l'entrée L_en de chaque unité afin de maintenir l'état du terminal de sortie O de chaque unité avant le passage dans un mode de repos. Ce signal de mémorisation et la cellule mémoire sont dans le domaine de la tension d'alimentation V_{DD} du circuit intégré, qui est toujours active dans un mode de repos et dans un mode de fonctionnement normal du circuit intégré.

De manière à supprimer tout courant transversal lors du passage dans un mode de repos après avoir mémorisé l'état de chaque terminal de sortie par l'intermédiaire de chaque cellule mémoire, chaque unité à décalage 2, 2', 2", 2"' comprend encore des moyens de blocage non représentés, qui fonctionnent dans le domaine de la tension d'alimentation V_{DD}. Un signal de blocage n_power_down est fourni en même temps à chaque entrée n_block de chaque unité à décalage de niveau. Grâce à ces moyens de blocage, uniquement des courants de fuites des éléments alimentés par la tension d'alimentation du circuit intégré subsistent dans ce mode de repos.

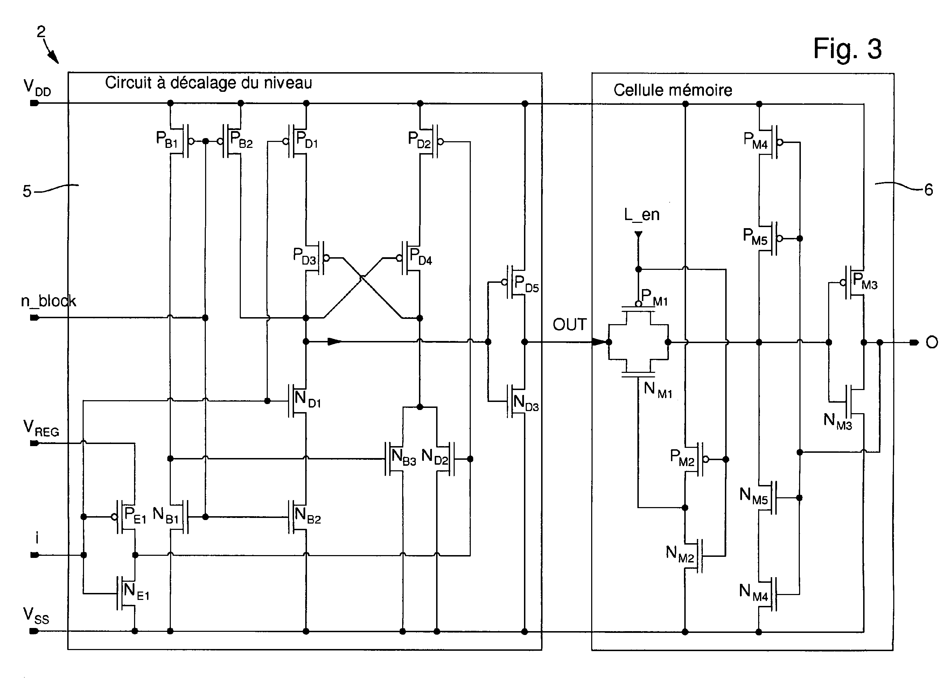

Normalement comme décrit en référence à la figure 3 ci-après, les moyens de blocage deviennent actifs quand le signal n_block est à l'état "0". Dans un mode de fonctionnement normal du circuit intégré, ce signal n_block doit être par contre à l'état "1" par exemple proche de V_{DD}. Ceci permet un transfert du signal de données ou de contrôle par l'unité à décalage de niveau de tension du domaine de la tension régulée V_{REG} au domaine de la tension d'alimentation V_{DD}.

Même s'il n'est représenté que quatre unités à décalage de niveau de tension à la figure 1, il peut tout à fait être concevable d'ajouter encore certaines unités à décalage de niveau de tension en parallèle. Il peut être prévu par exemple une ou plusieurs unités à décalage de niveau de tension pour recevoir des données (Input Enable en terminologie anglaise) par la plage de contact externe S_{P}. De ce fait en liaison à la plage de contact externe du circuit intégré, il peut être prévu une sortie numérique de données, une entrée numérique de données, une entrée numérique avec tirage vers le haut ou vers le bas, un état à drain ouvert et une sortie à trois états en mode analogique. Cependant pour ne pas surcharger la figure 1, uniquement quatre unités à décalage ont été représentées et décrites.

Le procédé de mise en action du dispositif de sauvegarde de la configuration des terminaux de sortie du circuit intégré peut être décrit pour le passage du mode de fonctionnement normal à un mode de repos et inversement. Dans une première étape dans le mode de fonctionnement normal, le signal de mémorisation L_en doit passer d'un état "0" à un état "1" pour commander l'opération de mémorisation par les cellules mémoires du dernier état de sortie de chaque unité à décalage du niveau de tension. Une fois que ce signal de mémorisation L_en est à l'état "1", tout changement du signal d'entrée i n'a plus aucune influence sur l'état en sortie de chaque unité à décalage 2, 2', 2" et 2"'.

Dans une seconde étape du procédé, la logique du circuit intégré commande le passage du mode de fonctionnement normal au mode basse consommation ou de repos. Dans ce mode de repos la tension régulée interne est coupée ou devient flottante, ce qui a pour conséquence une réduction de consommation électrique du circuit intégré de toutes les parties alimentées par cette tension régulée interne V_{REG}. Toutefois l'état de tous les terminaux de sortie des parties alimentées par la tension d'alimentation V_{DD}, est maintenu par le biais des cellules mémoires. Le signal de mémorisation L_en est de ce fait toujours maintenu à l'état "1 ".

Dans une troisième étape du procédé, le dispositif de sauvegarde est réveillé pour le passage du mode de repos au mode de fonctionnement normal. Dans cette troisième étape du procédé, la configuration des terminaux de sortie est toujours maintenue par les cellules mémoires commandées par le signal de mémorisation L_en à l'état "1", par exemple proche de V_{DD}.

Finalement dans une quatrième étape du procédé, le signal de mémorisation passe de l'état "1" à l'état "0". Dans cette condition, la configuration des terminaux de sortie peut changer en fonction des signaux de données ou de contrôle à l'entrée de chaque unité à décalage de niveau de tension.

S'il est prévu dans chaque unité à décalage de niveau de tension, des moyens de blocage des courants transversaux, ces moyens de blocage deviennent fonctionnels uniquement après la mémorisation de la configuration des terminaux de sortie, c'est-à-dire après la première étape du procédé. Les moyens de blocage peuvent être activés soit avant la seconde étape du procédé, soit au même moment ou légèrement après la seconde étape du procédé en fonction de la partie logique configurée du circuit intégré. Pour ce faire, le signal n_block doit passer de l'état "1" à l'état "0".

Les moyens de blocage des courants transversaux peuvent devenir inactifs après la troisième étape du procédé avec le signal n_block qui passe de l'état "0" à l'état "1 ". Ceci permet de pouvoir à nouveau transférer le signal de données ou de contrôle de l'étage d'entrée en sortie de la partie de transfert de chaque unité à décalage de niveau de tension.

Toutes les étapes du procédé de mise en action du dispositif de sauvegarde sont simples à concevoir avec une temporisation de tous les signaux, qui est contrôlée par logiciel. Il n'est ainsi prévu aucun ajout de blocs fonctionnels complémentaires, ce qui peut compliquer la conception du circuit intégré. De plus grâce au dispositif de sauvegarde de la présente invention, de bons niveaux logiques sont garantis par exemple lors du passage du mode de repos au mode de fonctionnement normal.

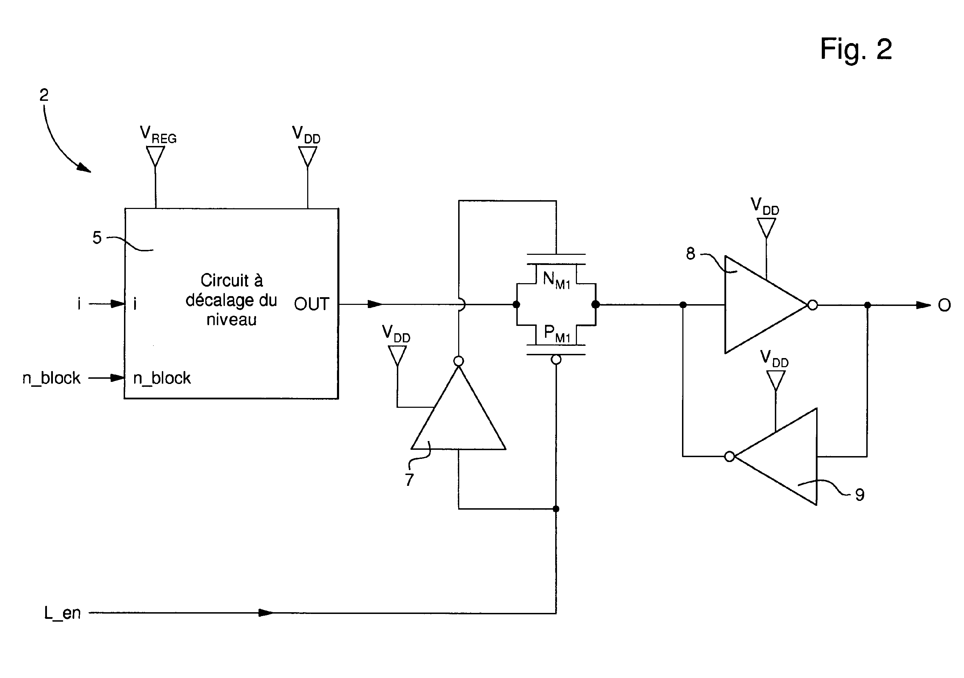

A la figure 2, il est représenté de manière schématique une unité à décalage de niveau de tension 2. Cette unité à décalage, déjà décrite en référence à la figure 1, comprend principalement un circuit à décalage du niveau de tension 5, qui peut être de conception traditionnelle en fonctionnement normal, et une cellule mémoire reliée en sortie OUT du circuit à décalage du niveau 5. Le circuit à décalage du niveau de tension 5 comprend un étage d'entrée recevant un signal de données ou de contrôle i, qui est alimenté par la tension régulée V_{REG}, et une partie de transfert d'un état d'une fonction en sortie OUT, qui est alimenté par la tension d'alimentation V_{DD} du circuit intégré. Cette partie de transfert comprend également en plus de la partie à décalage du niveau de tension traditionnel, les moyens de blocage des courants transversaux, qui seront décrits ci-après en détail en référence à la figure 3.

Il est à noter que l'état d'une fonction en sortie OUT dans la partie de transfert concerne le décalage en tension d'un signal de données i ou d'un signal de contrôle i. L'état de la sortie OUT est par contre bloqué à l'état "0" si le signal n_block est à l'état "0" quelque que soit le signal de données ou de contrôle en entrée i.

La cellule mémoire de l'unité à décalage de niveau de tension est composée de manière traditionnelle tout d'abord d'une paire de transistors NMOS N_{M1} et PMOS P_{M1} de conductivité différente montés en parallèle. La grille du premier transistor P_{M1} est commandée par le signal de mémorisation L_en, alors que la grille du second transistor N_{M1} est commandée par l'inverse du signal de mémorisation L_en. Pour ce faire, un premier inverseur rapide 7 est relié d'un côté à la grille du premier transistor P_{M1} et en sortie à la grille du second transistor N_{M1}. Ce premier inverseur est alimenté à la tension d'alimentation V_{DD} du circuit intégré.

Les drains de ces deux transistors NMOS N_{M1} et PMOS P_{M1} sont reliés en sortie OUT du circuit à décalage du niveau 5, alors que les sources de ces deux transistors sont reliées en entrée d'un second inverseur rapide 8 alimenté à la tension d'alimentation V_{DD}. La sortie de ce second inverseur est la sortie O de l'unité à décalage de niveau de tension. Un troisième inverseur faible 9 est encore relié entre la sortie O et l'entrée du second inverseur 8. Ce troisième inverseur faible 9 est également alimenté à la tension d'alimentation V_{DD}.

Le principe de mémorisation d'un état du terminal O par l'intermédiaire de la cellule mémoire ne sera pas expliqué en détail, car il fait partie des connaissances générales d'un homme du métier dans ce domaine technique. Il est juste noté que pour mémoriser un état en sortie de l'unité à décalage de niveau de tension, il est nécessaire que le signal de mémorisation L_en soit maintenu dans un état "1", c'est-à-dire normalement à la tension d'alimentation V_{DD}. Quand le signal L_en est à l'état "1", les deux transistors sont rendus non conducteurs pour la mémorisation d'un état de sortie au niveau de leur borne de source.

L'unité à décalage de niveau de tension est expliquée maintenant de manière plus détaillée en référence à la figure 3. Sur cette figure 3, on reconnaît principalement le circuit à décalage du niveau 5 et la cellule mémoire 6 comme décrits précédemment.

L'unité à décalage de niveau de tension 2 comprend tout d'abord un étage d'entrée alimenté à la tension régulée V_{REG}. Cet étage d'entrée est composé d'un inverseur ayant deux transistors PMOS P_{E1} et NMOS N_{E1} de conductivité différente connectés en série entre la borne de tension régulée V_{REG} et la borne de masse V_{SS}. La source du transistor P_{E1} est reliée à la borne de la tension régulée, alors que la source du transistor N_{E1} est reliée à la borne de masse. La grille de ces deux transistors P_{E1} et N_{E1} est commandée par le signal de données ou de contrôle i. Ce signal de données ou de contrôle commande également un premier transistor NMOS N_{D1} par sa grille et un premier transistor PMOS P_{D1} par sa grille de la partie de décalage du niveau de tension pour le transfert d'un état en sortie. Le noeud de connexion des drains de ces transistors d'entrée P_{E1} et N_{E1} est relié à la grille d'un second transistor NMOS N_{D2} et à la grille d'un second transistor PMOS P_{D2} de la partie de décalage du niveau traditionnel.

La partie à décalage du niveau de tension comprend donc le premier transistor PMOS P_{D1}, dont la source est reliée à la borne de la tension d'alimentation V_{DD}, le second transistor PMOS P_{D2}, dont la source est également reliée à la borne de la tension d'alimentation V_{DD}. Cette partie à décalage du niveau de tension comprend également une paire différentielle de transistors du type PMOS P_{D3} et P_{D4}, qui est une partie bistable bien connue. La source du troisième transistor P_{D3} est reliée au drain du premier transistor PMOS P_{D1} alors que la source du quatrième transistor P_{D4} est reliée au drain du second transistor PMOS P_{D2}. La grille du troisième transistor PMOS P_{D3} est reliée au drain du quatrième transistor P_{D4} et également au drain du second transistor NMOS N_{D2}, alors que la grille du quatrième transistor P_{D4} est reliée au drain du troisième transistor P_{D3,} ainsi qu'au drain du premier transistor NMOS N_{D1}. La source du second transistor NMOS N_{D2} est directement reliée à la borne de masse V_{SS}, alors que la source du premier transistor N_{D1}, qui devrait traditionnellement être reliée à la borne de masse, est par contre reliée au drain d'un transistor de blocage N_{B2} des moyens de blocage.

Le noeud de connexion du drain du premier transistor NMOS N_{D1} et du drain du troisième transistor PM OS P_{D3} est relié à un inverseur de sortie, qui fournit le signal de sortie OUT. Cet inverseur de sortie est composé de deux transistors PMOS P_{D5} et NMOS N_{D3} de conductivité différente, connectés en série entre la borne de tension d'alimentation V_{DD} et la borne de masse V_{SS}. La source du cinquième transistor PMOS P_{D5} est reliée à la borne de la tension d'alimentation V_{DD}, alors que la source du troisième transistor NMOS N_{D3} est reliée à la borne de masse. La grille de ces deux transistors P_{D5} et N_{D3} est commandée par le noeud de connexion des drains des transistors P_{D3} et N_{D1}, alors que le noeud de connexion des drains de ces deux transistors P_{D5} et N_{D3} constitue la borne de sortie OUT du circuit à décalage du niveau.

Les moyens de blocage font partie, dans le circuit à décalage du niveau 5, de la partie de transfert d'un état d'une fonction en sortie. Ces moyens de blocage comprennent tout d'abord des premier, second et troisième transistors NMOS N_{B1}, N_{B2} et N_{B3}, dont la source de chacun est directement reliée à la borne de masse V_{SS}, et des premier et second transistors PMOS P_{B1} et P_{B2}, dont la source de chacun est directement reliée à la borne de la tension d'alimentation V_{DD}.

La grille des premier et second transistors NMOS N_{B1} et N_{B2} est reliée à la grille des premier et second transistors PMOS P_{B1} et P_{B2}. La grille de ces transistors est commandée directement par le signal de blocage n_block. Le drain du premier transistor PMOS P_{B1} est relié au drain du premier transistor NMOS N_{B1}, ainsi qu'à la grille du troisième transistor NMOS N_{B3}. Le drain du troisième transistor NMOS N_{B3} est relié au drain du second transistor NMOS N_{D2}, au drain du quatrième transistor PMOS P_{D4} et à la grille du troisième transistor PMOS P_{D3} de la partie à décalage du niveau. Le drain du second transistor NMOS N_{B2} de blocage est relié à la source du premier transistor NMOS N_{D1} de la partie à décalage du niveau. Finalement le drain du second transistor PMOS P_{B2} de blocage est relié au noeud de connexion du drain du premier transistor NMOS N_{D1}, du drain du troisième transistor PMOS P_{D3} et de la grille du quatrième transistor PMOS P_{D4} de la partie à décalage du niveau.

Lorsque le signal de blocage n_block est à l'état "1 ", c'est-à-dire par exemple au niveau de la tension d'alimentation V_{DD}, le circuit à décalage du niveau fonctionne de manière traditionnelle. Les premier et second transistors NMOS N_{B1} et N_{B2} sont conducteurs ce qui permet de relier la source du premier transistor NMOS N_{D1} à la borne de masse et de rendre non conducteur le troisième transistor NMOS N_{B3} de blocage. Les deux transistors de blocage P_{B1} et P_{B2} sont par contre non conducteurs.

Pour garantir un blocage dans le circuit à décalage du niveau de tous les transistors dans un état bien défini pour n'avoir que des courants de fuites dans le mode basse consommation, le signal de blocage n_block est commandé par la logique du circuit intégré pour être dans un état "0" proche de la masse. Lorsque le signal de blocage n_block est à l'état "0", les deux transistors de blocage PMOS P_{B1} et P_{B2} deviennent conducteurs, alors que les deux transistors de blocage NMOS N_{B1} et N_{B2} deviennent non conducteurs. Le troisième transistor de blocage NMOS N_{B3} devient conducteur pour tirer la grille du troisième transistor PMOS P_{D3} et le drain du quatrième transistor PMOS P_{D4} vers la masse. Le second transistor de blocage PMOS P_{B2} devient conducteur et tire le noeud de connexion du drain du premier transistor NMOS N_{D1}, du drain du troisième transistor PMOS P_{D3} et de la grille du quatrième transistor PMOS P_{D4} de la partie à décalage du niveau, vers le haut à la tension d'alimentation V_{DD}. Ainsi la sortie OUT du circuit à décalage est bloqué à un état "0", quelque soit l'état du signal de données ou de contrôle i.

La cellule mémoire 6, qui est reliée à la sortie OUT du circuit à décalage du niveau de tension 5, comprend les mêmes éléments que ceux décrits en référence à la figure 2. De ce fait uniquement les inverseurs reliés à la paire de transistors P_{M1} et N_{M1}, dont le drain est relié à la sortie OUT, sont décrits en détails.

Le premier inverseur rapide de la cellule mémoire 6 comprend un second transistor PMOS P_{M2} et un second transistor NMOS N_{M2} montés en série entre la borne de la tension d'alimentation V_{DD} et la borne de masse V_{SS}. La source du second transistor P_{M2} est reliée directement à la borne de la tension d'alimentation V_{DD}, alors que la source du second transistor N_{M2} est reliée directement à la borne de masse Vss. La grille de ces deux transistors N_{M2} et P_{M2} est commandée par le signal de mémorisation L_en, ainsi que la grille du premier transistor PMOS P_{M1}, alors que le drain des deux transistors commande la grille du premier transistor NMOS N_{M1}.

Le second inverseur rapide de la cellule mémoire 6 comprend également deux transistors MOS montés en série entre la borne de la tension d'alimentation V_{DD} et la borne de masse V_{SS}. La source du troisième transistor PMOS P_{M3} est reliée directement à la borne de la tension d'alimentation V_{DD}, alors que la source du troisième transistor NMOS N_{M3} est reliée directement à la borne de masse V_{SS}. La grille de ces deux transistors N_{M3} et P_{M3} est reliée à la source des premiers transistors N_{M1} et P_{M1}, alors que le drain de ces deux transistors N_{M3} et P_{M3} constitue la sortie O de l'unité à décalage de niveau de tension 2.

Le troisième inverseur faible de la cellule mémoire 6 est relié en sens inverse entre la sortie et l'entrée du second inverseur. Ce troisième inverseur faible est composé d'une paire de transistors NMOS N_{M4} et N_{M5} en série et d'une paire de transistors PMOS P_{M4} et P_{M5} en série. Ces deux paires de transistors sont montées en série entre la borne de la tension d'alimentation V_{DD} et la borne de masse V_{SS}. La source du quatrième transistor PMOS P_{M4} est reliée directement à la borne de la tension d'alimentation, alors que la source du quatrième transistor NMOS N_{M4} est reliée directement à la borne de masse. Le drain du quatrième transistor PMOS P_{M4} est relié à la source du cinquième transistor P_{M5}, alors que le drain du quatrième transistor NMOS N_{M4} est relié à la source du cinquième transistor NMOS N_{M5}. Le drain des cinquièmes transistors N_{M5} et P_{M5} est relié à l'entrée du second inverseur, c'est-à-dire à la grille des troisièmes transistors N_{M3} et P_{M3}, alors que la grille des transistors N_{M4}, N_{M5}, P_{M4} et P_{M5} est reliée à la sortie du second inverseur, c'est-à-dire à la sortie O de l'unité à décalage de niveau de tension 2.

Il est à noter que l'agencement des deux paires de transistors du troisième inverseur a été choisi pour définir deux transistors PMOS et NMOS à grande longueur L de canal et courte largeur W de canal. Par contre les transistors PMOS et NMOS des premier et second inverseurs sont définis en comparaison avec de courte longueur L de canal et de grande largeur W de canal. Toutefois comme l'agencement est bien connu dans ce domaine technique, il ne sera pas expliqué en plus grand détail.

A partir de la description qui vient d'être faite, plusieurs variantes de réalisation du dispositif de sauvegarde et de son procédé de mise en action peuvent être conçues par l'homme du métier sans sortir du cadre de l'invention définie par les revendications. Le signal de blocage des moyens de blocage peut survenir à tout moment selon une programmation de la logique du circuit intégré ou de manière spontanée au passage du mode de fonctionnement normal au mode de repos après mémorisation de la configuration des terminaux de sortie. La tension d'alimentation du circuit intégré peut être d'un niveau inférieur ou supérieur à la tension régulée interne, qui est coupée dans le mode de repos du dispositif de sauvegarde.

## Revendications

1. Dispositif de sauvegarde (1) de la configuration de terminaux d'un circuit intégré à basse consommation, le dispositif comprenant :
- au moins une unité à décalage de niveau de tension (2, 2', 2", 2"'), qui comprend un circuit à décalage de niveau de tension (5) et une cellule mémoire (6) pour mémoriser un état de sortie d'une fonction de l'unité, le circuit à décalage de niveau de tension comprenant un étage d'entrée pour recevoir un signal de données ou de contrôle (i), et qui est alimenté sous une tension régulée interne (V_{REG}), qui est générée par un régulateur de tension à l'intérieur du circuit intégré, et une partie de transfert d'un état d'une fonction de l'unité en sortie (OUT) selon l'état du signal de données ou de contrôle, qui est alimentée sous la tension d'alimentation (V_{DD}) du circuit intégré, ladite partie de transfert d'un état d'une fonction étant reliée à l'étage d'entrée pour permettre de décaler en tension le signal de données ou de contrôle fourni à l'étage d'entrée, et
- un étage de sortie (3) alimenté sous la tension d'alimentation du circuit intégré, qui est relié à la sortie (O) de l'unité à décalage de niveau de tension et connecté à au moins une plage de contact externe (S_{P}) du circuit intégré,
**caractérisé en ce que** le dispositif de sauvegarde comprend plusieurs unités à décalage de niveau de tension (2, 2', 2", 2"') reliées en sortie à l'étage de sortie, les unités à décalage de niveau de tension comprenant chacune une cellule mémoire (6) alimentée par la tension d'alimentation et commandée par un même signal de mémorisation (L_en), pour mémoriser l'état de sortie en tension d'une fonction spécifique de l'unité à décalage de niveau respective dans un mode de repos du circuit intégré, où la tension régulée est coupée.

2. Dispositif de sauvegarde (1) selon la revendication 1, **caractérisé en ce que** chaque cellule mémoire (6) est reliée en sortie (OUT) de la partie de transfert d'un état d'une fonction spécifique de l'unité à décalage du niveau de tension correspondante.

3. Dispositif de sauvegarde (1) selon l'une des revendications précédentes, **caractérisé en ce qu'**il comprend au moins deux unités à décalage du niveau de tension, dont chaque cellule mémoire (6) est commandée par un même signal de mémorisation (L_en) pour mémoriser l'état des terminaux de sortie des unités pour le mode de repos, une première unité (2) ayant pour fonction de transmettre un signal de données (D_{OUT}) en sortie à une porte de transfert (4) de l'étage de sortie (3) dans un mode de fonctionnement normal, et une seconde unité (2') ayant pour fonction de fournir un premier signal de contrôle (oe) en sortie à la porte de transfert de l'étage de sortie pour commander la transmission du signal de données jusqu'à la plage de contact externe (Sp) du circuit intégré.

4. Dispositif de sauvegarde (1) selon la revendication 3, **caractérisé en ce qu'**il comprend en outre une troisième unité à décalage du niveau de tension (2") ayant pour fonction de commander par un second signal de contrôle (n_en_pull_up) à l'étage de sortie (3) un tirage vers le haut de la plage de contact externe (S_{P}) du circuit intégré dans un mode de fonctionnement normal, et **en ce qu'**il comprend en outre une quatrième unité à décalage du niveau de tension (2"') ayant pour fonction de commander par un troisième signal de contrôle (en_pull_down) à l'étage de sortie un tirage vers la bas de la plage de contact externe (S_{P}) du circuit intégré dans un mode de fonctionnement normal.

5. Dispositif de sauvegarde (1) selon l'une des revendications 3 et 4, **caractérisé en ce que** l'étage de sortie (3) comprend une porte de transfert à trois états (4) recevant en entrée un signal de données décalé en tension de la première unité à décalage du niveau de tension (2) dans un mode de fonctionnement normal, ladite porte de transfert à trois états étant commandée par un premier signal de contrôle (oe) fourni par la seconde unité à décalage du niveau de tension (2'), la sortie de la porte de transfert étant reliée à la plage de contact externe (S_{P}), et **en ce que** l'étage de sortie comprend un premier transistor PMOS (P_{S}) et un second transistor NMOS (N_{S}) montés en série entre une borne de tension d'alimentation (V_{DD}) et une borne de masse (V_{SS}), et une résistance (R_{P}) reliant le drain des deux transistors à la plage de contact externe, le premier transistor étant commandé par la troisième unité à décalage du niveau de tension (2") pour opérer un tirage vers le haut, alors que le second transistor étant commandé par la quatrième unité à décalage du niveau de tension (2"') pour opérer un tirage vers le bas.

6. Dispositif de sauvegarde (1) selon l'une des revendications précédentes, **caractérisé en ce que** chaque unité à décalage du niveau de tension comprend dans la partie de transfert d'un état d'une fonction en sortie, des moyens de blocage (N_{B1}, N_{B2}, N_{B3}, P_{B1}, P_{B2}) alimentés à la tension d'alimentation (V_{DD}) du circuit intégré, ces moyens de blocage étant prévus pour fixer un état déterminé en sortie par des transistors à décalage du niveau de tension de la partie de transfert, suite à la mémorisation d'un état d'une fonction dans la cellule mémoire (6) dans un mode de repos.

7. Dispositif de sauvegarde (1) selon la revendication 6, **caractérisé en ce que** les moyens de blocage de chaque unité à décalage du niveau de tension sont commandés par un même signal de blocage (n_block) pour fixer un état déterminé en sortie de chaque unité par les transistors à décalage du niveau de tension.

8. Dispositif de sauvegarde (1) selon l'une des revendications 6 et 7, **caractérisé en ce que** la partie de transfert d'un état d'une fonction de chaque unité à décalage de niveau de tension, comprend connectés en série entre deux bornes d'une source de tension d'alimentation du circuit intégré deux transistors PMOS (P_{D1}, P_{D2}), une paire de transistors PMOS différentiels à connexion croisée (P_{D3}, P_{D4}), et deux transistors NMOS (N_{D1}, N_{D2}), la grille d'un premier transistor PMOS (P_{D1}) et la grille d'un premier transistor NMOS (N_{D1}) étant reliées pour recevoir le signal de données ou de contrôle (i), alors que la grille d'un second transistor PMOS (P_{D2}) et la grille d'un second transistor NMOS (N_{D2}) sont reliées pour recevoir le signal de données ou de contrôle inversé, le drain du premier transistor NMOS (N_{D1}) et le drain d'un premier transistor différentiel PMOS (P_{D3}) relié à la grille d'un second transistor différentiel PMOS (P_{D4}) étant connectés à un inverseur (P_{D5}, N_{D3}) pour fournir le signal de données ou de contrôle en sortie décalé en tension.

9. Dispositif de sauvegarde (1) selon la revendication 8, **caractérisé en ce que** les moyens de blocage comprennent une paire de transistors PMOS (P_{B1}, P_{B2}) reliés à la borne de potentiel haut de la tension d'alimentation (V_{DD}), et une paire de transistors NMOS (N_{B1}, N_{B2}) reliés à la borne de masse (V_{SS}), les grilles des transistors PMOS et NMOS étant reliées pour être commandées par un même signal de blocage (n_block), les drains des premiers transistors PMOS et NMOS de chaque paire étant reliés pour commander la grille d'un transistor de blocage NMOS (N_{B3}) connecté en parallèle du second transistor NMOS (N_{D2}) de la partie de transfert et relié à la grille du premier transistor différentiel PMOS (P_{D3}), le second transistor NMOS (N_{B2}) de la paire étant relié en série avec le premier transistor NMOS (N_{D1}) de la partie de transfert pour relier à la masse la source du premier transistor NMOS, quand le signal de blocage rend conducteur la paire de transistors NMOS dans un mode de fonctionnement normal, et le drain du second transistor PMOS (P_{B2}) de la paire étant relié aux drains du premier transistor NMOS et du premier transistor différentiel PMOS de la partie de transfert, ainsi qu'à la grille du second transistor différentiel PMOS pour fixer un état déterminé en sortie quand les transistors PMOS de la paire sont rendus conducteurs dans un mode de repos.

10. Procédé de mise en action d'un dispositif de sauvegarde (1) de la configuration de terminaux d'un circuit intégré à basse consommation selon l'une des revendications précédentes, **caractérisé en ce qu'**il comprend pour le passage d'un mode de fonctionnement normal à un mode de repos et inversement, les étapes consistant à :
- commander au moyen d'un même signal de mémorisation (L_en) les cellules mémoires de toutes les unités à décalage de niveau de tension (2, 2', 2", 2"') pour la mémorisation par chaque cellule mémoire (6) du dernier état de sortie (O) des terminaux de sortie des unités à décalage du niveau de tension (2, 2', 2", 2"'),
- commander le passage du mode de fonctionnement normal au mode basse consommation ou de repos, dans lequel la tension régulée interne (V_{REG}) est coupée ou devient flottante, le dernier état de sortie des terminaux étant maintenu par les cellules mémoires activées par le signal de mémorisation,
- réveiller après un laps de temps déterminé ou suite à une commande externe, le dispositif de sauvegarde pour le passage du mode de repos au mode de fonctionnement normal avec la tension régulée en fonction, le dernier état de sortie des terminaux de sortie étant maintenu par les cellules mémoires activée par le signal de mémorisation, et
- désactiver le signal de mémorisation pour changer selon les signaux de données ou de contrôle la configuration des terminaux de sortie de chaque unité à décalage du niveau de tension.

11. Procédé selon la revendication 10, pour lequel le dispositif de sauvegarde comprend des moyens de blocage de la partie de transfert d'un état d'une fonction en sortie dans chaque unité à décalage du niveau de tension, **caractérisé en ce que** les moyens de blocage sont mis en fonction pour fixer un état déterminé en sortie (OUT) après la commande par le signal de mémorisation (L_en) de la mémorisation de la configuration des terminaux de sortie dans chaque cellule mémoire (6), et **en ce que** les moyens de blocage deviennent inactifs après le réveil du dispositif de sauvegarde, mais avant la désactivation du signal de mémorisation.

12. Procédé selon la revendication 11, **caractérisé en ce que** les moyens de blocage sont mis en fonction au même moment de la commande du passage du mode de fonctionnement normal au mode de repos ou un laps de temps suivant cette opération.

## Claims

1. Device (1) for backing up the configuration of terminals of a low-power integrated circuit, the device including :
- at least one voltage level shift unit (2, 2', 2", 2"'), which includes a voltage level shift circuit (5) and a memory cell (6) for storing an output state of a unit function, the voltage level shift circuit including an input stage that receives a data or control signal (i), and which is powered by a regulated internal voltage (V_{REG}), which is generated by a voltage regulator inside the integrated circuit, and a part for transferring the output state (OUT) of a unit function according to the state of the data or control signal, which is powered by a supply voltage (V_{DD}) of the integrated circuit, said transfer part of a state of a function being connected to the input stage for voltage shifting the data or control signal provided at input stage, and
- an output stage (3) powered by the integrated circuit supply voltage, which is connected to the output (O) of the voltage level shift unit and connected to at least one external contact pad (S_{P}) of the integrated circuit,
**characterized in that** the backup device includes several voltage level shift units (2, 2', 2", 2"') connected to the output to the output stage, the voltage level shift units each including a memory cell (6) powered by the supply voltage and controlled by a same storage signal (L_en), for storing the output voltage state of a specific function of the respective level shift unit in an idle mode of the integrated circuit where the regulated voltage is cut off.

2. Backup device according to claim 1, **characterized in that** each memory cell (6) is connected to the output (OUT) of the state transfer part for the specific function of the corresponding voltage level shift unit.

3. Backup device (1) according to any of the preceding claims, **characterized in that** it includes at least two voltage level shift units, whose each memory cell (6) is controlled by a same storage signal (L_en) for storing the output terminal state of the units for the idle mode, a first unit (2) whose function is to transmit a data signal (d_{OUT}) at the output to a buffer (4) of the output stage (3) in normal operating mode, and a second unit (2') whose function is to supply a first control signal (oe) at the output to the buffer of the output stage to control transmission of the data signal to the external contact pad (S_{P}) of the integrated circuit.

4. Backup device (1) according to claim 3, **characterized in that** it further includes a third voltage level shift unit (2") whose function is to control, via a second control signal (n_en_pull_up) the output stage (3) to pull up the external contact pad (S_{P}) of the integrated circuit in normal operating mode, and **in that** it further includes a fourth voltage level shift unit (2'") whose function is to control, via a third control signal (en_pull_down) the output stage to pull down the external contact pad (S_{P}) of the integrated circuit in normal operating mode.

5. Backup device (1) according to any of claims 3 and 4, **characterized in that** the output stage (3) includes a tri-state buffer (4) that receives at input a voltage shifted data signal from the first voltage level shift unit (2) in normal operating mode, said tri-state buffer being controlled by a first control signal (oe) supplied by the second voltage level shift unit (2'), the output of the buffer being connected to the external contact pad (S_{P}), and **in that** the output stage includes a first PMOS transistor (P_{S}) and a second NMOS transistor (N_{S}) series-mounted between a supply voltage terminal (V_{DD}) and an earth terminal (V_{SS}), and a resistor (R_{P}) that connects the drain of the two transistors to the external contact pad, the first transistor being controlled by the third voltage level shift unit (2") for pulling up, whereas the second transistor is controlled by the fourth voltage level shift unit (2"') for pulling down.

6. Backup device (1) according to any of the preceding claims, **characterized in that** each voltage level shift unit includes, in the output function state transfer part, blocking means (N_{B1}, N_{B2}, N_{B3}, P_{B1}, P_{B2}) powered by the integrated circuit supply voltage (V_{DD}), said blocking means being provided for fixing a determined state in output by voltage level shift transistors of the transfer part following the storage of a state of a function in memory cell (6) in an idle mode.

7. Backup device (1) according to claim 6, **characterized in that** the blocking means of each voltage level shift unit are controlled by a same blocking signal (n_block) for fixing a determined state in output of each unit independently of any data or control signal (i) in idle mode, when the regulated internal voltage is cut off.

8. Backup device (1) according to any of the claims 6 and 7, **characterized in that** the transfer part of a state of a function of each voltage level shift unit, includes two PMOS transistors (P_{D1}, P_{D2}) series-connected between two terminals of an integrated circuit supply voltage source, differential pair of crossed-connection PMOS transistors (P_{D3}, P_{D4}), and two NMOS transistors (N_{D1}, N_{D2}), the gate of a first PMOS transistor (P_{D1}) and the gate of a first NMOS transistor (N_{D1}) being connected to receive the data or control signal (i), whereas the gate of a second PMOS transistor (P_{D2}) and the gate of a second NMOS transistor (N_{D2}) being connected to receive the reversed data or control signal, the drain of the first NMOS transistor (N_{D1}) and the drain of a first differential PMOS transistor (P_{D3}) connected to the gate of a second differential PMOS transistor (P_{D4}) being connected to an inverter (P_{D5}, N_{D3}) to supply the data or control signal in output voltage shifted.

9. Backup device (1) according to claim 8, **characterized in that** the blocking means include a pair of PMOS transistors (P_{B1}, P_{B2}) connected to the high potential terminal of supply voltage (V_{DD}), and a pair of NMOS transistors (N_{B1}, N_{B2}) connected to the earth terminal (V_{SS}), the gates of PMOS and NMOS transistors being connected to be controlled by a same blocking signal (n_block), the drains of first PMOS and NMOS transistors of each pair being connected to control the gate of a blocking NMOS transistor (N_{B3}) connected in parallel of the second NMOS transistor (N_{D2}) of the transfer part and connected to the gate of the first differential PMOS transistor (P_{D3}), the second NMOS transistor (N_{B2}) of the pair being series-connected with the first NMOS transistor (N_{D1}) of the transfer part to connect to earth the source of first NMOS transistor, when the blocking signal makes conductive the pair of NMOS transistors in a normal operating mode, and the drain of second PMOS transistor (P_{B2}) of the pair being connected to the drains of the first NMOS transistor and first differential PMOS transistor of the transfer part, and to the gate of a second differential PMOS transistor to fix a determined state in output, when the PMOS transistors of the pair are made conductive in an idle mode.

10. Method of enabling a device (1) for backing up the terminal configuration of a low-power integrated circuit according to any of the preceding claims, **characterized in that**, for passage from normal operating mode to idle mode, it includes the following steps:
- enabling by means of a same storage signal (L_en) the memory cells of all the voltage level shift units (2, 2', 2", 2"') for storage by each memory cell (6) of the last output state (O) of the output terminals of the voltage level shift units (2, 2', 2", 2"'),
- enabling passage from normal operating mode to low-power or idle mode, wherein the regulated internal voltage (V_{REG}) is cut off or becomes floating, the last output state of the terminals being maintained by the enabled memory cells by the storage signal,
- waking up after a determined period of time or after an external command, the backup device for passage from idle mode to normal operating mode with the operating regulated voltage, the last output state of the output terminals being maintained by the memory cells enabled by the storage signal, and
- deactivating the storage signal to change, in accordance with the data or control signals, the output terminal configuration of each voltage level shift unit.

11. Method according to claim 10, wherein the backup device includes means for blocking of the output function state transfer part in each voltage level shift unit, **characterized in that** the blocking means are enabled to fix an output determined state (OUT) after the command by the storage signal (L_en) for storage of the output terminal configuration in each memory cell (6), and **in that** the blocking means become inactive after the backup device has woken up, but prior to deactivation of the storage signal.

12. Method according to claim 11, **characterized in that** the blocking means are enabled at the same time as the command to pass from normal operating mode to idle mode or after a period of time that follows said operation.

## Patentansprüche

1. Vorrichtung (1) für die Sicherung der Konfiguration von Anschlüssen einer integrierten Schaltung mit niedrigem Verbrauch, wobei die Vorrichtung umfasst:
- wenigstens eine Spannungspegel-Verschiebungseinheit (2, 2', 2", 2"'), die eine Spannungspegel-Verschiebungsschaltung (5) und eine Speicherzelle (6) zum Speichern eines Ausgangszustands einer Funktion der Einheit enthält, wobei die Spannungspegel-Verschiebungsschaltung eine Eingangsstufe umfasst, um ein Daten- oder Steuersignal (i) zu empfangen, die mit einer internen regulierten Spannung (V_{REG}) versorgt wird, die durch einen Spannungsregulierer innerhalb der integrierten Schaltung erzeugt wird, und einen Abschnitt für die Übertragung eines Zustands einer Funktion der Einheit an den Ausgang (OUT) gemäß dem Zustand des Daten- oder Steuersignals enthält, der mit einer Versorgungsspannung (V_{DD}) der integrierten Schaltung versorgt wird, wobei der Abschnitt für die Übertragung eines Zustands einer Funktion mit der Eingangsstufe verbunden ist, um die Verschiebung der Spannung des Daten- oder Steuersignals, das an die Eingangsstufe geliefert wird, zu ermöglichen, und
- eine Ausgangsstufe (3), die mit der Versorgungsspannung der integrierten Schaltung versorgt wird, die mit dem Ausgang (O) der Spannungspegel-Verschiebungseinheit verbunden ist und an wenigstens einen externen Kontaktbereich (S_{P}) der integrierten Schaltung angeschlossen ist,
**dadurch gekennzeichnet, dass** die Sicherungsvorrichtung mehrere Spannungspegel-Verschiebungseinheiten (2, 2', 2", 2"') umfasst, die mit ihrem Ausgang mit der Ausgangsstufe verbunden sind, wobei die Spannungspegel-Verschiebungseinheiten jeweils eine Speicherzelle (6) enthalten, die mit der Versorgungsspannung versorgt und mit demselben Speichersignal (L_en) gesteuert wird, um den Ausgangsspannungszustand einer bestimmten Funktion der jeweiligen Pegel-Verschiebungseinheit in einer Ruhebetriebsart der integrierten Schaltung, in der die regulierte Spannung unterbrochen ist, zu speichern.

2. Sicherungsvorrichtung (1) nach Anspruch 1, **dadurch gekennzeichnet, dass** jede Speicherzelle (6) mit dem Ausgang (OUT) des Abschnitts für die Übertragung eines Zustands einer bestimmten Funktion der entsprechenden Spannungspegel-Verschiebungseinheit verbunden ist.

3. Sicherungsvorrichtung (1) nach einem der vorhergehenden Ansprüche, **dadurch gekennzeichnet, dass** sie wenigstens zwei Spannungspegel-Verschiebungseinheiten umfasst, deren jeweilige Speicherzelle (6) durch dasselbe Speichersignal (L_en) gesteuert wird, um den Zustand der Ausgangsanschlüsse der Einheiten für die Ruhebetriebsart zu speichern, wobei eine erste Einheit (2) die Funktion hat, in einer Normalfunktionsbetriebsart ein Datensignal (d_{OUT}) am Ausgang an ein Übertragungsgatter (4) der Ausgangsstufe (3) zu übertragen, und eine zweite Einheit (2') die Funktion hat, ein erstes Steuersignal (oe) am Ausgang zu dem Übertragungsgatter der Ausgangsstufe zu liefern, um die Übertragung des Datensignals bis zu dem externen Kontaktbereich (S_{P}) der integrierten Schaltung zu steuern.

4. Sicherungsvorrichtung (1) nach Anspruch 3, **dadurch gekennzeichnet, dass** sie außerdem eine dritte Spannungspegel-Verschiebungseinheit (2") umfasst, die die Funktion hat, in einer Normalfunktionsbetriebsart durch ein zweites Steuersignal (n_en_pull_up) zu der Ausgangsstufe (3) ein Hochziehen des externen Kontaktbereichs (S_{P}) der integrierten Schaltung zu steuern, und dass sie außerdem eine vierte Spannungspegel-Verschiebungseinheit (2"') umfasst, die die Funktion hat, in einer Normalfunktionsbetriebsart durch ein drittes Steuersignal (en_pull_down) zu der Ausgangsstufe ein Herunterziehen des externen Kontaktbereichs (S_{P}) der integrierten Schaltung zu steuern.

5. Sicherungsvorrichtung (1) nach einem der Ansprüche 3 und 4, **dadurch gekennzeichnet, dass** die Ausgangsstufe (3) ein Übertragungsgatter (4) mit drei Zuständen umfasst, das in einer Normalfunktionsbetriebsart am Eingang ein spannungsverschobenes Datensignal von der ersten Spannungspegel-Verschiebungseinheit (2) empfängt, wobei das Übertragungsgatter mit drei Zuständen durch ein erstes Steuersignal (oe) gesteuert wird, das von der zweiten Spannungspegel-Verschiebungseinheit (2') geliefert wird, wobei der Ausgang des Übertragungsgatters mit dem externen Kontaktbereich (S_{P}) verbunden ist, und dass die Ausgangsstufe einen ersten PMOS-Transistor (P_{S}) und einen zweiten NMOS-Transistor (N_{S}) umfasst, die zwischen einem Versorgungsspannungsanschluss (V_{DD}) und einem Masseanschluss (V_{SS}) in Reihe geschaltet sind, und einen Widerstand (R_{P}) umfasst, der den Drain der zwei Transistoren mit dem externen Kontaktbereich verbindet, wobei der erste Transistor durch die dritte Spannungspegel-Verschiebungseinheit (2") gesteuert wird, um ein Hochziehen zu bewerkstelligen, während der zweite Transistor durch die vierte Spannungspegel-Verschiebungseinheit (2"') gesteuert wird, um ein Herunterziehen zu bewerkstelligen.

6. Sicherungsvorrichtung (1) nach einem der vorhergehenden Ansprüche, **dadurch gekennzeichnet, dass** jede Spannungspegel-Verschiebungseinheit in dem Abschnitt für die Übertragung eines Zustands einer Funktion am Ausgang Sperrmittel (N_{B1}, N_{B2}, N_{B3}, P_{B1}, P_{B2}) umfasst, die mit der Versorgungsspannung (V_{DD}) der integrierten Schaltung versorgt werden, wobei diese Sperrmittel vorgesehen sind, um in einer Ruhebetriebsart einen Zustand, der am Ausgang durch Spannungspegel-Verschiebungstransistoren des Übertragungsabschnitts bestimmt wird, nach dem Speichern eines Zustands einer Funktion in der Speicherzelle (6) zu fixieren.

7. Sicherungsvorrichtung (1) nach Anspruch 6, **dadurch gekennzeichnet, dass** die Sperrmittel jeder Spannungspegel-Verschiebungseinheit durch dasselbe Sperrsignal (n_block) gesteuert werden, um einen Zustand, der am Ausgang jeder Einheit durch die Spannungspegel-Verschiebungstransistoren bestimmt wird, zu fixieren.

8. Sicherungsvorrichtung (1) nach einem der Ansprüche 6 und 7, **dadurch gekennzeichnet, dass** der Abschnitt für die Übertragung eines Zustands einer Funktion jeder Spannungspegel-Verschiebungseinheit in einer Reihenschaltung zwischen zwei Anschlüssen einer Versorgungsspannungsquelle der integrierten Schaltung zwei PMOS-Transistoren (P_{D1}, P_{D2}), ein Paar differentieller PMOS-Transistoren (P_{D3}, P_{D4}) in gekreuzter Schaltung und zwei NMOS-Transistoren (N_{D1}, N_{D2}) umfasst, wobei das Gate eines ersten PMOS-Transistors (P_{D1}) und das Gate eines ersten NMOS-Transistors (N_{D1}) verbunden sind, um das Daten- oder Steuersignal (i) zu empfangen, während das Gate eines zweiten PMOS-Transistors (P_{D2}) und das Gate eines zweiten NMOS-Transistors (N_{D2}) verbunden sind, um das invertierte Daten- oder Steuersignal zu empfangen, wobei der Drain des ersten NMOS-Transistors (N_{D1}) und der Drain eines ersten differentiellen PMOS-Transistors (P_{D3}), der mit dem Gate eines zweiten differentiellen PMOS-Transistors (P_{D4}) verbunden ist, an einen Invertierer (P_{D5}, N_{D3}) angeschlossen sind, um das spannungsverschobene Daten- oder Steuersignal am Ausgang zu liefern.

9. Sicherungsvorrichtung (1) nach Anspruch 8, **dadurch gekennzeichnet, dass** die Sperrmittel ein Paar PMOS-Transistoren (P_{B1}, P_{B2}), die mit dem Anschluss mit hohem Potential der Versorgungsspannung (V_{DD}) verbunden sind, und ein Paar NMOS-Transistoren (N_{B1}, N_{B2}), die mit dem Masseanschluss (V_{SS}) verbunden sind, umfasst, wobei die Gates der PMOS- und NMOS-Transistoren verbunden sind, um mit demselben Sperrsignal (n_block) gesteuert zu werden, wobei die Drains der ersten PMOS- und NMOS-Transistoren jedes Paars verbunden sind, um das Gate eines NMOS-Sperrtransistors (N_{B3}) zu steuern, der parallel zu dem zweiten NMOS-Transistor (N_{D2}) des Übertragungsabschnitts geschaltet ist und mit dem Gate des ersten differentiellen PMOS-Transistors (P_{D3}) verbunden ist, wobei der zweite NMOS-Transistor (N_{B2}) des Paars mit dem ersten NMOS-Transistor (N_{D1}) des Übertragungsabschnitts in Reihe geschaltet ist, um die Source des ersten NMOS-Transistors mit Masse zu verbinden, wenn das Sperrsignal das Paar NMOS-Transistoren in einer Normalfunktionsbetriebsart durchschaltet, und wobei der Drain des zweiten PMOS-Transistors (P_{B2}) des Paars mit den Drains des ersten NMOS-Transistors und des ersten differentiellen PMOS-Transistors des Übertragungsabschnitts sowie mit dem Gate des zweiten differentiellen PMOS-Transistors verbunden ist, um einen bestimmten Zustand am Ausgang zu fixieren, wenn die PMOS-Transistoren des Paars in einer Ruhebetriebsart durchgeschaltet werden.

10. Verfahren zum Betreiben einer Vorrichtung (1) für die Sicherung der Konfiguration von Anschlüssen einer integrierten Schaltung mit niedrigem Verbrauch nach einem der vorhergehenden Ansprüche, **dadurch gekennzeichnet, dass** es für den Übergang von einer Normalfunktionsbetriebsart in eine Ruhebetriebsart und umgekehrt die Schritte umfasst, die darin bestehen:
- mit demselben Speichersignal (L_en) die Speicherzellen aller Spannungspegel-Verschiebungseinheiten (2, 2', 2", 2"') zu steuern, um mit jeder Speicherzelle (6) den letzten Ausgangszustand (O) der Ausgangsanschlüsse der Spannungspegel-Verschiebungseinheiten (2, 2', 2", 2"') zu speichern,
- den Übergang von der Normalfunktionsbetriebsart in die Niedrigverbrauchs- oder Ruhebetriebsart, in der die interne regulierte Spannung (V_{REG}) unterbrochen ist oder schwebend wird, zu steuern, wobei der letzte Ausgangs-zustand der Anschlüsse durch die Speicherzellen, die durch das Speichersignal aktiviert sind, gehalten wird,
- nach dem Verstreichen einer bestimmten Zeit oder nach einem externen Befehl die Sicherungsvorrichtung aufzuwecken, um von der Ruhebetriebsart in die Normalfunktionsbetriebsart mit der regulierten Funktionsspannung überzugehen, wobei der letzte Ausgangszustand der Ausgangsanschlüsse durch die durch das Speichersignal aktivierten Speicherzellen gehalten wird, und
- Deaktivieren des Speichersignals, um entsprechend den Daten- oder Steuersignalen die Konfiguration der Ausgangsanschlüsse jeder Spannungspegel-Verschiebungseinheit zu ändern.

11. Verfahren nach Anspruch 10, wobei die Sicherungsvorrichtung Sperrmittel für den Abschnitt für die Übertragung eines Zustands einer Funktion am Ausgang in jeder Spannungspegel-Verschiebungseinheit umfasst, **dadurch gekennzeichnet, dass** die Sperrmittel betrieben werden, um einen bestimmten Ausgangszustand (OUT) nach der Steuerung durch das Speichersignal (L_en) des Speicherns der Konfiguration der Ausgangsanschlüsse in jeder Speicherzelle (6) zu fixieren, und dass die Sperrmittel nach dem Aufwecken der Sicherungsvorrichtung, jedoch vor der Deaktivierung des Speichersignals, inaktiv werden.

12. Verfahren nach Anspruch 11, **dadurch gekennzeichnet, dass** die Sperrmittel zum gleichen Zeitpunkt wie die Steuerung des Übergangs von der Normalfunktionsbetriebsart in die Ruhebetriebsart oder nach dem Verstreichen einer Zeit nach dieser Operation betrieben werden.
